Europäisches Patentamt

European Patent Office

Office européen des brevets

(19)

(11) **EP 0 739 531 B1**

(12) **EUROPÄISCHE PATENTSCHRIFT**

(45) Veröffentlichungstag und Bekanntmachung des Hinweises auf die Patenterteilung:
**08.07.1998 Patentblatt 1998/28**

(21) Anmeldenummer: **95904959.4**

(22) Anmeldetag: **12.01.1995**

(51) Int Cl.⁶: **H01J 37/30**, H01J 37/12

(86) Internationale Anmeldenummer:
**PCT/AT95/00003**

(87) Internationale Veröffentlichungsnummer:
**WO 95/19637 (20.07.1995 Gazette 1995/31)**

(54) **TEILCHENOPTISCHES ABBILDUNGSSYSTEM**

PARTICLE BEAM OPTIC REPRODUCTION SYSTEM

SYSTEME DE REPRODUCTION OPTIQUE PAR FAISCEAUX DE PARTICULES

(84) Benannte Vertragsstaaten:
**DE**

(30) Priorität: **13.01.1994 AT 47/94**

(43) Veröffentlichungstag der Anmeldung:
**30.10.1996 Patentblatt 1996/44**

(73) Patentinhaber: **IMS Ionen Mikrofabrikations Systeme Gesellschaft m.b.H.
A-1020 Wien (AT)**

(72) Erfinder:
- **STENGL, Gerhard**
  **A-9241 Wernberg (AT)**
- **CHALUPKA, Alfred**
  **A-1130 Wien (AT)**
- **VONACH, Herbert**
  **A-3400 Klosterneuburg (AT)**

(74) Vertreter: **Rieberer, Stefan, Dipl.-Ing.
Patentanwalt,
Dipl.-Ing. Franz Matschnig,
Siebensterngasse 54
1071 Wien (AT)**

(56) Entgegenhaltungen:
**EP-A- 0 564 438**

- **38TH INTERNATIONAL SYMPOSIUM ON ELECTRON ION AND PHOTON BEAMS (EIPB'94), NEW ORLEANS, LA, USA, 31 MAY-3 JUNE 1994, Bd. 12,Nr. 6, ISSN 0734-211X, JOURNAL OF VACUUM SCIENCE & TECHNOLOGY B (MICROELECTRONICS AND NANOMETER STRUCTURES), NOV.-DEC. 1994, USA, Seiten 3513-3517, CHALUPKA A ET AL 'Novel electrostatic column for ion projection lithography'**

**Beschreibung**

Unter den verschiedenen Schritten, die zur Herstellung von Halbleiterbauelementen ausgeführt werden müssen, ist der Lithographieschritt besonders wichtig. Vereinfacht ausgedrückt, beginnt jeder Lithographieschritt mit dem Aufbringen einer dünnen Schicht aus lichtempfindlichem (bzw. teilchenstrahlempfindlichem) Material, dem sogenannten Photoresist oder kurz "Resist" auf einen Wafer, insbesondere aus Silizium. Ein Lithographiegerät projiziert dann die auf einer Maske vorhandene Struktur in Gestalt einer oder mehrerer transparenter Stellen auf den mit dem Resist versehenen Wafer. Zwischen Maske und Wafer befinden sich gegebenenfalls optische Elemente. Die Ausdehnung der projizierten Struktur der Maske auf dem Wafer ist meist sehr viel kleiner als der Wafer. Anschließend an die Projektion wird der Wafer verschoben und dieselbe Struktur der Maske auf eine andere Stelle des Wafers projiziert. Dieser Vorgang des Projizierens und Verschiebens wird solange wiederholt, bis die gesamte Waferfläche genutzt ist. Durch nachfolgendes Entwickeln des Resists wird auf dem Wafer das gewünschte Muster beispielsweise in Form von resistfreien Stellen erhalten. Der Wafer kann dann in weiteren Schritten irgendeinem der bekannten Bearbeitungsvorgänge wie Ätzen, Ionenimplantation oder Aufbringen und Diffusion von Dotierungsmaterial unterzogen werden. Nach diesen weiteren Schritten wird der Wafer kontrolliert, wieder mit Resist überzogen und die gesamte vorerwähnte Schrittfolge etwa 10 - 20 mal wiederholt, bis schließlich eine schachbrettartige Anordnung von identischen Mikroschaltkreisen auf dem Wafer erzeugt ist.

Die meisten heute verwendeten Projektionslithographieverfahren verwenden Licht zur Bestrahlung des Resists, aber das Bedürfnis nach kleineren Strukturen und höherer Dichte der Komponenten der Mikroschaltkreise hat dazu geführt, intensiv nach anderen Bestrahlungsmethoden zu suchen, die in ihrer Auflösung nicht wie bei Anwendung von Licht durch dessen relativ große Wellenlänge beschränkt sind. Große Anstrengungen wurden unternommen, um Röntgenstrahlen in Lithographiegeräten zu verwenden, während andere Verfahren wie z.B. die Teilchen- insbesondere Ionenstrahllithographie, zwar einige, aber doch wesentlich weniger Beachtung erfahren haben.

Für teilchenoptische Abbildungssysteme für Lithographiezwecke, mit einer Teilchenquelle zur Abbildung einer auf einer Maske befindlichen Struktur in Gestalt einer oder mehrerer Öffnungen über mindestens zwei zwischen der Maske und einem Wafer befindliche Sammellinsen auf den Wafer wurde bereits durch die europäische Patentanmeldung EP-A-0 564 438 vorgeschlagen, mindestens eine der Sammellinsen als sogenannte Dreielektroden-Gitterlinse auszubilden, welche aus zwei Rohrelektroden besteht, zwischen denen sich eine dritte Elektrode befindet, welche als Platte mit einer Vielzahl von Öffnungen, bevorzugt als Gitter, ausgebildet ist, wobei die Platte, insbesondere das Gitter, senkrecht zur optischen Achse angeordnet ist, so daß durch die Platte bzw. das Gitter die Linse in zwei Bereiche geteilt ist, wobei bevorzugt an die drei Elektroden unterschiedliche Spannungen angelegt werden. Einer der Linsenbereiche der Dreielektroden-Gitterlinse mit Gitter als mittlerer Elektrode kann positive Brechkraft aufweisen, der zweite Linsenbereich jedoch negative Brechkraft, wobei der absolute Wert der Brechkraft des negative Brechkraft aufweisenden Linsenbereiches (zerstreuender Bereich) geringer ist als die Brechkraft des positive Brechkraft aufweisenden Linsenbereiches (sammelnder Bereich). Bei einem solchen Abbildungssystem können sich trotz der verschiedenen Absolutbeträge der Brechkräfte die Bildfehlerkoeffizienten größtenteils kompensieren, wenn der zerstreuende Bereich entsprechend größere Bildfehler 3. Ordnung besitzt als der sammelnde Bereich.

Die Anwendung einer Dreielektroden-Gitterlinse ermöglicht es somit, jeweils einen Bildfehlerkoeffizienten in den Abbildungsgleichungen dieser Linse zum Verschwinden zu bringen, wobei auch die übrigen Bildfehlerkoeffizienten kleine Werte annehmen im Vergleich zu den zum Beispiel aus den durch die Europäischen Patent-Anmeldungen EP-A- 0 344 646, EP-A- 0 523 033, EP-A- 0 528 785 bekannten elektrostatischen Linsen. Erreicht wird dies durch die Einführung der Platten- bzw. Gitter-Elektrode, da es nur mit einer solchen Elektrode möglich ist, eine elektrostatische Zerstreuungslinse herzustellen. Darüberhinaus tritt in ionenoptischen Lithographiesystemen mit Dreielektroden-Gitterlinsen auch eine Reduzierung der resultierenden Verzeichnung an der Stelle des Verzeichnungsminimums auf. Die Anwendung von Dreielektrodenlinsen mit Gitter als mittlerer Elektrode erlaubt überdies die Verringerung des Abstandes Maske-Wafer gegenüber bekannten Systemen, wenn man die Verzeichnungswerte auf gleiche Bildfeldgröße bezieht. Schließlich wird auch noch die Schärfentiefe des Abbildungssystems wesentlich erhöht, weil die Dreielektrodenlinsen mit Gitter als mittlerer Elektrode jeweils nur sehr kleine Bildfehler besitzen und daher die Kompensation der Bildfehler bei den zwischen Wafer und Maske befindlichen Linsen weniger kritisch ist.

Im wesentlichen kann dieselbe Wirkung erzielt werden, wenn die Reihenfolge von Zerstreuungs- und Sammellinsen umgekehrt wird, wenn also beispielsweise die als Gitter ausgebildete Elektrode die erste Elektrode einer zerstreuenden Zweielektroden-Gitterlinse bildet, auf welche eine beispielsweise als Feldlinse ausgebildete Sammellinse folgt. Hiebei versteht man unter Feldlinse oder Immersionslinse eine Anordnung aus zwei koaxialen, rotationssymmetrischen Elektroden (z.B. rohrförmig ausgebildet), die sich auf verschiedenen Potentialen befinden.

Störungen durch die Öffnungen in der Platte bzw. durch die Gitteröffnungen können vermindert werden, wenn einerseits die Gitteröffnungen und ihre Abstände sehr klein gehalten werden (in der Größenordnung von Mikrometern) und zu beiden Seiten des Gitters, im Bereich der Ausleuchtung durch den Ionenstrahl möglichst gleiche Feldstärken vorhanden sind.

Das Problem bei der Verwendung von Gittern liegt darin, daß dieses, wegen der feinen Öffnungen und Stege, sehr dünn, dabei aber doch relativ grossflächig sein muss, und daher sehr empfindlich gegenüber Beschädigungen ist, sodass es sowohl im Zuge der Herstellung als auch dann im Laufe des Einsatzes in der Linse ständiger Kontrollen bedarf. Zu diesem Zwecke muss das Gitter aus der Maschine herausgenommen, gegebenenfalls gereinigt und wieder an seinen Platz gebracht werden, wobei es aufgrund seiner Fragilität jedesmal der Gefahr einer Beschädigung oder Zerstörung ausgesetzt ist.

Aufgabe der Erfindung ist es daher, diesem Problem abzuhelfen. Hierzu schlägt die Erfindung für die Ausgestaltung eines teilchenoptischen Abbildungssystems für Lithographiezwecke, mit einer Teilchenquelle zur Abbildung einer auf einer Maskenfolie befindlichen Struktur in Gestalt einer oder mehrerer transparenter Stellen, insbesondere Öffnungen über mindestens zwei in Strahlrichtung vor einem Wafer angeordnete elektrostatische Linsen auf den Wafer, wobei mindestens eine der Linsen eine sogenannte Gitterlinse ist, welche von einer oder zwei Rohrelektroden und einer im Strahlengang angeordneten Platte mit Öffnungen gebildet ist, wobei die Platte normal zur optischen Achse angeordnet ist, vor, daß erfindungsgemäß die Platte von der Maskenfolie gebildet ist, welche die mittlere oder die in Strahlrichtung erste Elektrode der Gitterlinse bildet. Hierbei bilden jeweils die Maske zusammen mit der in Ionenstrahlrichtung nachfolgenden Elektrode eine Zerstreuungslinse, deren Bildfehler 3. Ordnung durch die der nachfolgende(n) Sammellinse (n) bis auf minimale Restwerte kompensiert werden.

Durch den Ersatz des Gitters der bekannten Ausführung durch die Maske ist nur mehr ein Element, das bei der Fertigung und der Anwendung höchste Präzision erfordert, vorhanden, nämlich die Maske selbst, die auch bei allen anderen Ausführungsformen mit ebenso großer Präzision herzustellen ist, jedoch entfällt das weitere, ebenfalls mit hoher Präzision herzustellende Element und damit auch Fehler, die Unvollkommenheiten dieses zweiten Elementes bedingen.

In weiterer Ausgestaltung der Erfindung besitzt das ionenoptische Abbildungssystem, in dem die Maske die Mittelelektrode einer Dreielektroden-Gitterlinse darstellt, als weiteres Abbildungselement eine Sammellinse in Form einer Feldlinse oder einer asymmetrischen Einzellinse. Hiebei ist unter asymmetrischer Einzellinse eine Dreielektroden-Linse zu verstehen, bei der sich alle Elektroden auf verschiedenen Potentialen befinden. Asymmetrische Einzel linsen werden verwendet, weil sie erheblich kleinere Bildfehler besitzen als Immersionslinsen mit äquivalenten Abbildungseigenschaften.

In der Dreielektroden-Gitterlinse, deren Mittelelektrode nunmehr die Maske ist, stellt der erste Bereich praktisch die Beleuchtungslinse für die Maske dar und der zweite Bereich die Zerstreuungslinse (negative Brechkraft), deren Fehler durch die im Strahlengang nachfolgenden Linsen weitestgehend kompensiert werden.

In einer anderen Ausführungsform, bei der die Maske die erste Elektrode einer Zweielektroden-Gitterlinse bildet, folgen im Strahlengang auf diese Linse eine Feldlinse und danach eine asymmetrische Einzellinse. In diesem Fall werden die Abbildungsfehler der letzten Linse vor dem Wafer durch die Fehler der die Maske enthaltenden Zerstreuungslinse und der darauffolgenden Linse kompensiert.

Dadurch, daß nun die Maske an den Ort, wo sich bei der bekannten Ausführung (europäische Patentanmeldung EP-A- 0 564 438) das Gitter befand, gelegt wird, wird nunmehr die Gitterebene zur Gegenstandsebene. Dabei bilden die Öffnungen in der Maske Aperturlinsen, ebenso wie die Öffnungen des Gitters in der bekannten Ausführung. Da jedoch die Maske nun der abzubildende Gegenstand ist, welcher in der Bildebene abgebildet wird, ist gemäß den optischen Gesetzen eine geringe Änderung des Winkels der aus den Maskenöffnungen austretenden Teilchen in der Wirkung auf die Abbildung weitgehend zu vernachlässigen, da ja sämtliche von einem Gegenstandspunkt ausgehenden Teilchen in einem Bildpunkt gesammelt werden.

In weiterer Ausgestaltung derjenigen erfindungsgemäßen Ausfiihrungsform, in welcher die Maske die erste Elektrode einer Zweielektroden-Gitterlinse bildet, liegt der Kreuzungspunkt der Strahlen ("Cross-over") im feldfreien Raum in Strahlrichtung vor der letzten Linse vor dem Wafer, somit zwischen der Feldlinse und der asymmetrischen Einzellinse. Hiebei kann, in einer weiteren Ausgestaltung der Erfindung, vorgesehen sein, dass die Feldlinse die Ionen auf eine Energie beschleunigt, die hoch genug ist, dass die sogenannten stochastischen Raumladungseffekte (s.u.) minimiert werden. In der asymmetrischen Einzellinse kann die Energie der Ionen gegebenenfalls auf die am Wafer erwünschte Energie vermindert werden.

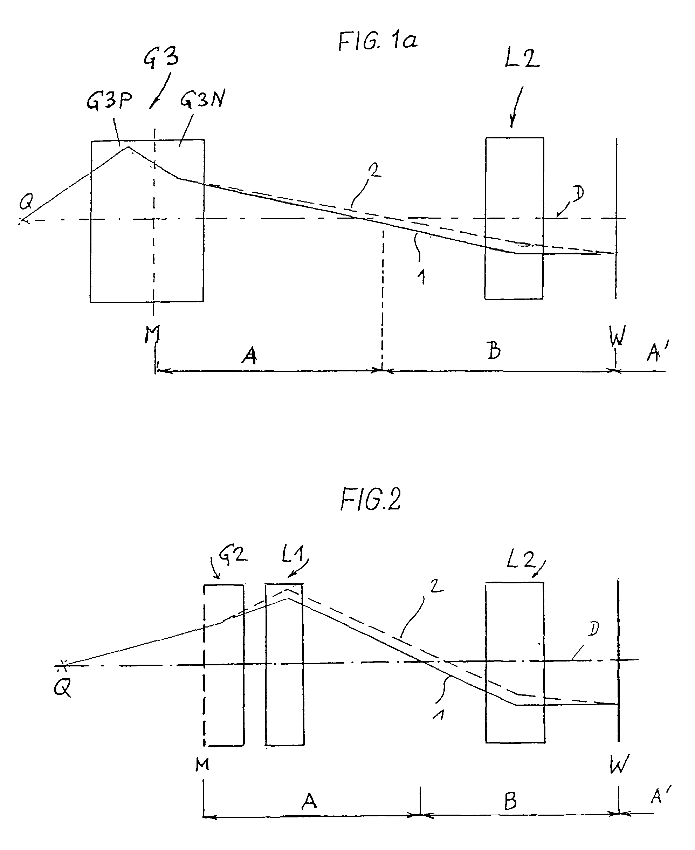

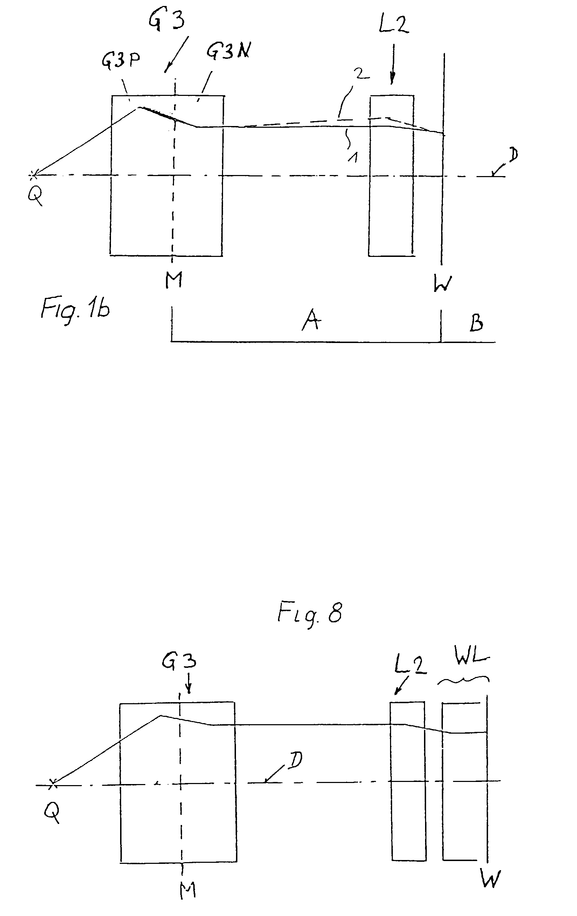

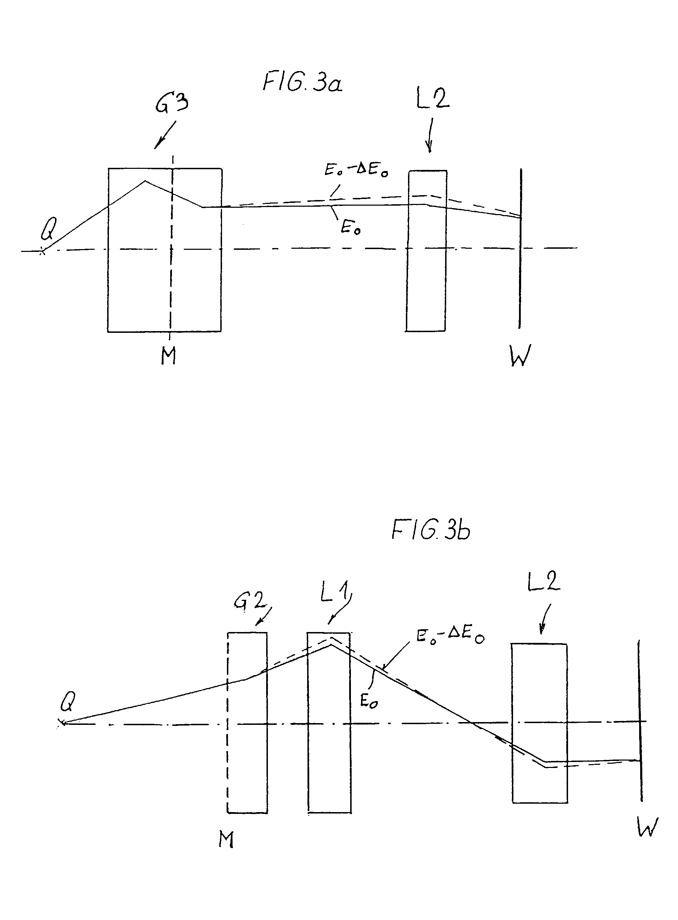

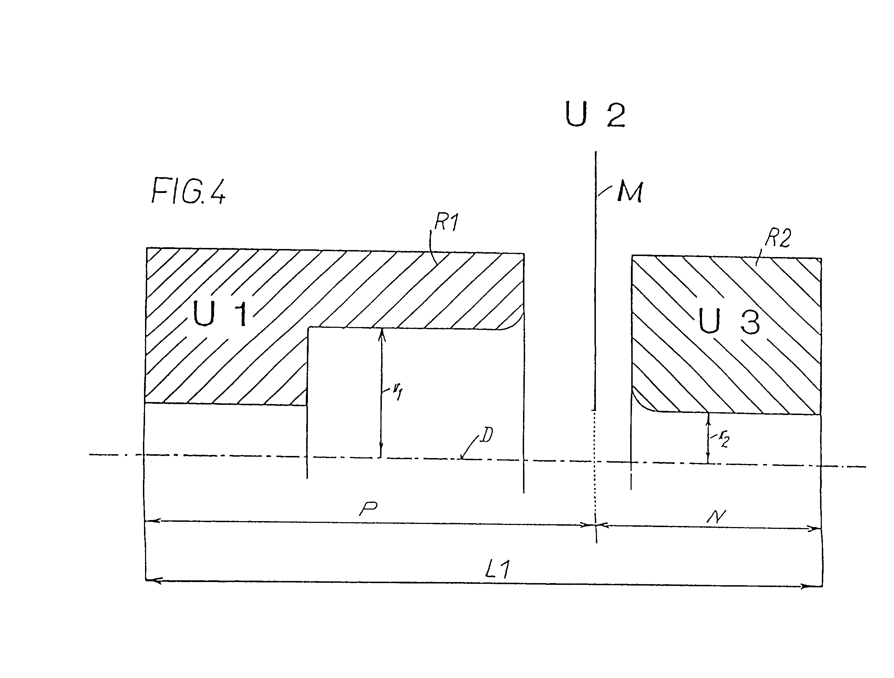

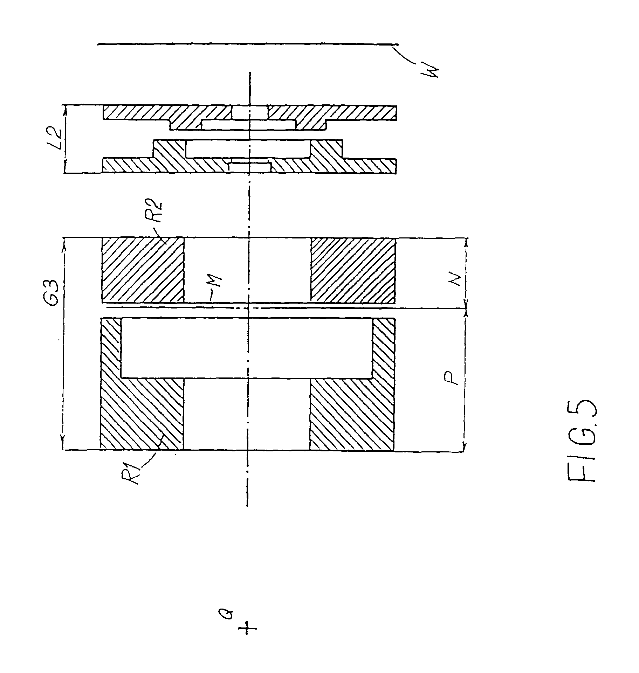

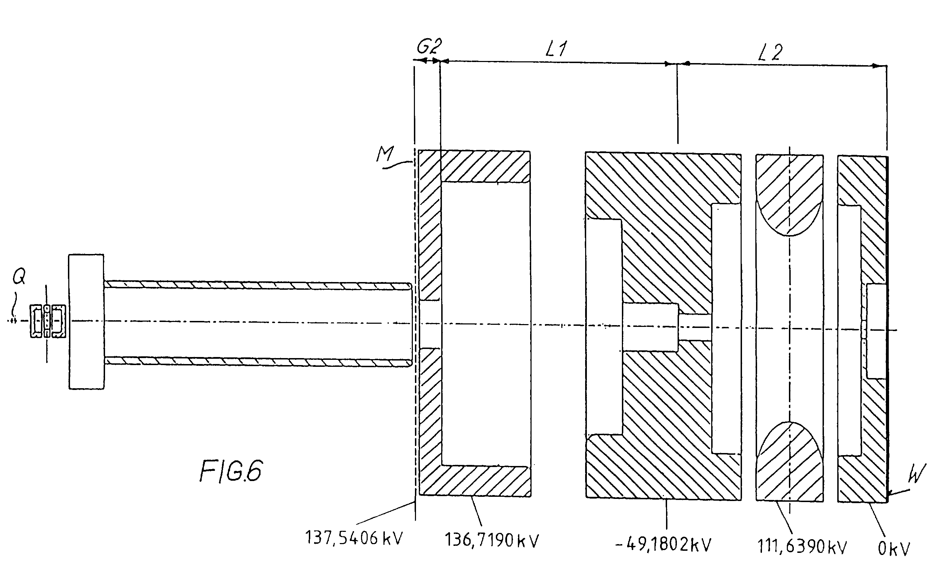

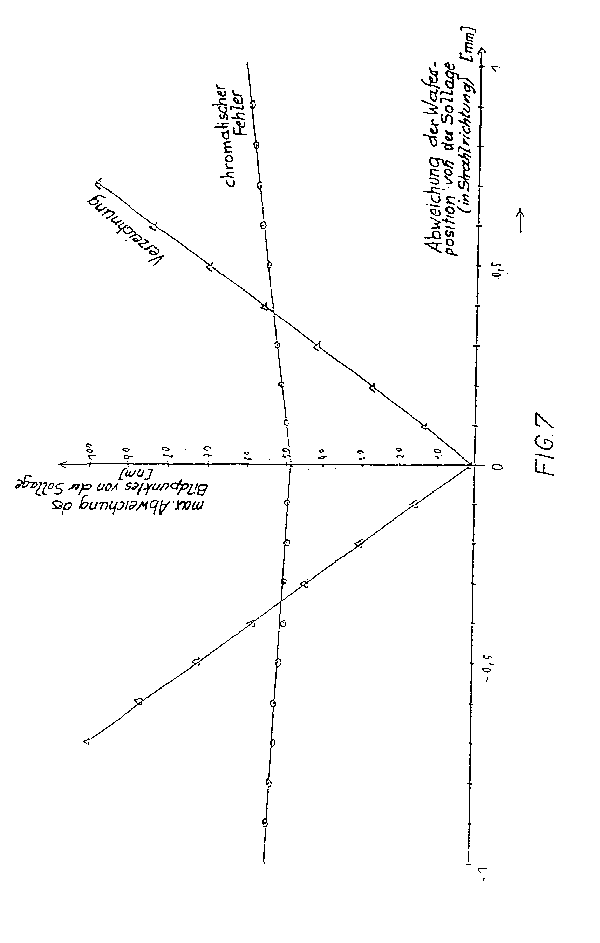

Die Erfindung wird nachstehend beispielsweise an Hand der Zeichnung näher erläutert. Es zeigen Fig. 1a, schematisiert und vereinfacht in einer Seitenansicht, den Aufbau und Strahlengang eines erfindungsgemässen Ionenlithograhpiesystems der ersten Ausführungsform mit Kreuzungspunkt, mit Verzeichnungskorrektur, Fig. 1b die analoge Ansicht der ersten Ausführungsform ohne Kreuzungspunkt, Fig. 2 ein Ionenlithographiesystem der zweiten Ausführungsform mit Verzeichnungskorrektur, Fig. 3a und b ebenfalls Ionenlithographiesysteme der in Fig. 1a und 1b sowie Fig.2 dargestellten Art mit Korrektur des chromatischen Fehlers, Fig. 4 in axialem Längsschnitt eine drei Elektroden aufweisende Linse, wobei die mittlere Elektrode von der Maske gebildet ist, Fig. 5 ebenfalls in axialem Längsschnitt eine Kombination aus einer Sammellinse gemäß Fig. 4 mit einer weiteren, als Feldlinse ausgebildeten, vor dem Wafer angeordneten Linse, Fig. 6, teilweise in axialem Längsschnitt und vereinfacht, eine Ionenprojektionseinrichtung mit einer Zweielektroden-Gitterlinse, in der die Maske die Gitter-Elektrode bildet, Fig. 7 den Verlauf des chromatischen

EP 0 739 531 B1

Auflösungsfehlers und der Verzeichnung in Abhängigkeit von der Waferposition für eine Anordnung gemäß Fig. 6, Fig. 8 eine Ansicht analog derjenigen von Fig. 1b, jedoch mit Korrekturlinse vor dem Wafer und Fig. 9 einen ebenen Schnitt durch ein konkretes Ausführungsbeispiel einer Anordnung nach Fig.6.

Gemäss Fig. 1(a und b) besitzt das ionenoptische Abbildungssystem eine Ionenquelle Q zur Abbildung einer auf einer Maske M befindlichen Struktur auf einen Wafer W. Die Struktur liegt dabei als mindestens eine Offnung der Maske M vor. In der ersten Ausfuehrungsform sind zwei der Elektroden, wie Fig. 4 und Fig.5 näher veranschaulichen, als Rohrelektroden R1 und R2 ausgebildet und die zwischen diesen Rohrelektroden R1 und R2 angeordnete, dritte Elektrode wird von der Maske M gebildet. Die Maske M ist senkrecht zur optischen Achse D des Abbildungssystems angeordnet und teilt die Linse L1 in zwei Bereiche P und N. An den drei Elektroden, nämlich den beiden Rohrelektroden R1 und R2 und der von der Maske M gebildeten Elektrode liegen unterschiedliche Potentiale U1, U2 und U3. mit 1 ist in der Zeichnung der Soll-Strahl und mit 2 der Ist-Strahl bezeichnet.

In dem beschriebenen Beispiel besitzt der Linsenbereich P positive und der Linsenbereich N negative Brechkraft, wobei jedoch der Absolutbetrag der Brechkraft des negative Brechkraft aufweisenden Linsenbereiches N geringer ist als die Brechkraft des positive Brechkraft aufweisenden Linsenbereiches P, so daß die Gesamtbrechkraft der Dreielektrodenlinse G3 positiv ist.

Aus Fig. 4 und Fig.5 ist weiters ersichtlich, daß die Rohrelektrode R2 des Linsenbereiches N von negativer Brechkraft, geringeren (etwa halb so großen) Durchmesser wie der der Maske zugekehrte Teil der Rohrelektrode R1 des Linsenbereiches P mit positiver Brechkraft aufweist. Das Spannungsverhältnis $(U3 - U0)/(U2 - U0)$ zwischen den Elektroden des negative Brechkraft aufweisenden Linsenbereiches N ist ebenfalls geringer (etwa ein Drittel) wie das Spannungsverhältnis $(U3 - U0)/(U1 - U0)$ zwischen den Elektroden des positive Brechkraft aufweisenden Linsenbereiches P, wobei U0 jenes Potential ist, bei dem die kinetische Energie der verwendeten geladenen Teilchen zu Null wird.

Zu beiden Seiten der Maske M wird möglichst gleiche Feldstärke für jenen Bereich angestrebt, der vom Ionenstrahlbündel ausgeleuchtet ist.

In der Dreielektroden-Gitterlinse, die als Gitter nunmehr die Maske besitzt, stellt der erste Bereich praktisch die Beleuchtungslinse für die Maske dar und der zweite Bereich die Zerstreuungslinse (negative Brechkraft), deren Fehler durch die nachfolgende Sammellinse L2 weitestgehend kompensiert werden. Dadurch, daß nunmehr die Maske an den Ort, wo sich bei der bekannten Ausführung (europäische Patentanmeldung 93 890 058.6) das Gitter befanc elegt wird, wird nunmehr die Gitterebene zur Gegenstandsebene. Es bilden dabei die Öffnungen in der Maske praktisch die Öffnungen des Gitters, wobei die Maskenöffnungen dieselbe Wirkung haben wie die Aperturlinsen der Gitteröffnungen selbst. Da jedoch, wie bereits erwähnt, die Maske M nun der in der optischen Säule abzubildende Gegenstand ist, welcher in der Bildebene abgebildet wird, ist gemäß den optischen Gesetzen eine geringe Änderung des Winkels der aus den Maskenöffnungen austretenden Teilchen in der Wirkung auf die Abbildung zu vernachlässigen, da ja sämtliche von einem Gegenstandspunkt ausgehenden Teilchen in einem Bildpunkt gesammelt werden.

Diese Erläuterungen gelten sowohl für die Ausbildung der zweiten Linse L2 als asymmetrische Einzellinse als auch als Feldlinse.

Die Maske M, welche die abzubildende Struktur in Form von Öffnungen in einer Folie (z.B. aus Silizium) aufweist, wird von einer Ionenquelle Q mit sehr geringer virtueller Quellengröße (annähernd 10 µm) und dieser nachfolgender Beleuchtungseinrichtung, welche zwei Multipole und einen zwischen ihnen angeordneten Massenseparator (z.B. ExB-Filter) und gegebenenfalls ein Diagnosesystem aufweisen kann, beleuchtet und befindet sich in einer ersten Ausführungsform zwischen den endständigen Elektroden der aus drei Elektroden R1, R2 und M bestehenden Linse G3 mit insgesamt positiver Brechkraft.

In einer speziellen Ausführungsform (Fig. 1a) erzeugt die Linse G3 einen Kreuzungsbereich (Cross-over) C, d. i ein reelles Bild der Ionenquelle Q hinter ihrem bildseitigen Brennpunkt. Der gegenstandsseitige Brennpunkt der vor dem Wafer W angeordneten zweiten Sammellinse L2 befindet sich ungefähr am Ort des Cross-overs C. Damit verlassen alle Strahlen die Sammellinse L2 nahezu achsparallel und man erhält ein annähernd telezentrisches Abbildungssystem. Dieses hat den Vorteil, daß sich der Abbildungsmaßstab bei kleinen Verschiebungen des Wafers W in Richtung der ionenoptischen Achse nicht ändert.

In einer weiteren Ausführungsform (Fig. 1b) kann bei dieser Anordnung ein Bild der Maske auch ohne Kreuzungspunkt erzeugt werden. Bei einer verkleinernden Abbildung geht damit die Telezentrizität verloren, wobei sehr kleine Winkel (ca 6 mrad) am Wafer trotzdem noch möglich sind. Um wieder ein telezentrisches System zu erhalten, kann erfindungsgemäß eine Korrekturlinse WL direkt vor dem Wafer angeordnet sein (Fig. 8), durch welche die Strahlen am Wafer wieder nahezu achsparallel auftreffen. Erfindungsgemäß kann diese Korrekturlinse dadurch gebildet werden, daß eine einzelne im wesentlichen rohrförmige Elektrode direkt vor dem Wafer positioniert ist und gegenüber diesem geringfügig unterschiedliches Potential besitzt. Diese Elektrode bildet zusammen mit dem Wafer die sogenannte Waferlinse WL, welche wieder eine Platte, nämlich den Wafer selbst, als Elektrode besitzt und daher als Zerstreuungslinse betrieben werden kann. Dies ist dann der Fall, wenn das Potential an der vor dem Wafer liegenden Elektrode so gewählt wird, daß die Ionen zum Wafer hin abgebremst werden.

In einer konkreten Ausführung der Dreielektrodenlinse mit Gitter ist der Abstand zwischen den einander zugekehrten Enden der Rohrelektroden R1, R2 135 mm. Die als Maske M ausgebildete Elektrode ist in einem Abstand von 90 mm von der Austrittsmündung der Rohrelektrode R1 angeordnet, wobei der Durchmesser der Austrittsmündung 600 mm beträgt, wogegen der Durchmesser der Eintrittsmündung der Rohrelektrode R2 300 mm beträgt. Die Austrittsmündung der Rohrelektrode R2 ist von der als Maske M ausgebildeten Elektrode 675 mm entfernt und die Eintrittsmündung der Rohrelektrode R1 liegt 1350 mm vor der die Mittenelektrode bildenden Maske. In einem Abstand von 585 mm von der der Maske M zugekehrten Austrittsmündung vermindert sich der Innendurchmesser der Rohrelektrode R1 von 600 auf 300 mm.

Bei der in Fig.6 dargestellten Ausführungsvariante bildet die Maske M die erste Elektrode der zerstreuenden Gitterlinse G2. Auf diese folgt die Sammellinse L1, hierauf die zweite Sammellinse L2, die vor der Waferebene im Strahlengang liegt und als asymmetrische EINZEL-Linse ausgebildet ist. Da das Potential der letzten Elektrode einer Linse immer dasselbe ist wie das der ersten Elektrode der nachfolgenden Linse, können diese beiden Elektroden physisch jeweils als eine einzige Elektrode ausgebildet werden, wie auch in Fig. 6 zu sehen ist. Man kann daher auch die gesamte ionenoptische Säule zwischen Maske und Wafer als eine einzige "Multi-Elektroden-Linse", diesfalls als Fünf-Elektroden-Linse, ansehen, welche verschiedene brechende Bereiche, nämlich G2, L1 und L2 aufweist. Gegebenenfalls, zum Beispiel um den Abstand zwischen Quelle und Wafer zu verkürzen, kann auch noch eine Beleuchtungslinse vor der Maske vorgesehen sein (eine solche ist in Fig. 6 nicht eingezeichnet).

Unterschiedlich zu der zuvor beschriebenen Dreielektrodenlinse, in der die Maske M die Mittelelektrode bildet, ist bei der Anordnung gemäß Fig. 6 die Feldstärke vor und nach der Maske verschieden groß, sodaß es zu Minilinseneffekten (flies' eyes lens effects) kommt, verursacht durch die Öffnungen in der Maske M. Da jedoch die elektrische Feldstärke an der Ebene der Maske M, welche der zweiten Elektrode zugekehrt ist, sehr gering ist, und weil die Maske der abzubildende Gegenstand ist, ist die Wirkung dieser Minilinsen vernachlässigbar klein. Die geringe Feldstärke ist erwünscht, da wegen der Arbeit, die eine sich in einem elektrischen Feld bewegende Folie leisten muß, allfällige Vibrationen der Maske M vermieden werden. Dies ermöglicht ein rasches Wechseln und Einrichten der Maske M. Die Anordnung gemäß Fig. 6 erlaubt es, das Bild der Maskenöffnungen mit einer Telezentrizität besser als 2 mrad auf die Ebene des Wafers W zu werfen. Diese hohe Telezentrizität ergibt in der Ebene des Wafers W eine Schärfentiefe von etwa 10 μm. Es werden damit in dieser Ausführungsform nicht nur der Abbildungsmaßstab und die Auflösung auch bei Änderungen der Waferlage in der optischen Achse aufrechterhalten, sondern es kann auch der besonders geringe Verzeichnungsfehler aufrechterhalten werden.

Bei dem Konzept gemäß Fig. 6 trifft in einem $60 \times 60 \text{ mm}^2$ großen Maskenstrukturfeld der Ionenstrahl unter Winkeln auf, die am Rand des Maskenfeldes geringer als 1,5° sind. Die Maskenöffnungen können in einer 3 μm starken Silizium-Folie mit einer Schräge von z.B. 3° realisiert werden. Damit können in einer 3 μm dicken Maskenfolie Linienraster mit einer Öffnungsbreite von z.B. 0,45μm realisiert werden, ohne daß Schattenfehler durch die Maskenkanten entstehen. Der Abstand zwischen Wafer W und Maske M beträgt beispielsweise 2171,51 mm und der größte Durchmesser 1180 mm.

Die erfindungsgemäßen Vorrichtungen besitzen unabhängig von der Realisierung die folgenden Eigenschaften:

a) Bei Anordnungen mit Cross-over erhält das Strahlenbündel im allgemeinen durch die auf die Maske M folgende und/oder diese enthaltende(n) Sammellinse G3N (Fig. 1) bzw. G2 und L1 (Fig.2) eine kissenförinige Rest-Verzeichnung (Bereich A), die nach dem Cross-over in eine tonnenförmige Rest-Verzeichnung (Bereich B) übergeht.

Fig. 1a und 2 veranschaulichen, daß durch die Verzeichnung der vor dem Wafer W angeordneten Sammellinse L2, die Strahlen eine zusätzliche Ablenkung erhalten, die den Bereich B tonnenförmiger Verzeichnung reduziert und einen an den Bereich tonnenförmiger Verzeichnung anschließenden Bereich A' kissenförmiger Verzeichnung generiert. Nach Fig. 1b wird bei der Anordnung ohne Cross-over die durch die Sammellinse G3N generierte kissenförmige Verzeichnung durch die Linse L2 reduziert und schließlich in eine tonnenförmige Verzeichnung (Bereich B) übergeführt.

Dabei gibt es hinter der vor dem Wafer W angeordneten Sammellinse L2 eine Ebene, in der sich die durch die zwischen Maske und Wafer liegenden Linsen hervorgerufenen Verzeichnungen kompensieren (Ebene minimaler Verzeichnung). Dies gilt allerdings nur für den Verzeichnungsfehler dritter Ordnung, es bleiben die sehr viel kleineren Verzeichnungsfehler fünfter und höherer Ordnung, so daß die Verzeichnung nicht zur Gänze verschwindet, sondern lediglich ein ausgeprägtes Minimum besitzt. Bei Verwendung einer Waferlinse WL (s.u.) kann diese noch zur weiteren Verzeichnungsminimierung beitragen.

Die Abhängigkeit der Restverzeichnung von der Abweichung in Strahlrichtung der Waferposition von der Sollage verläuft in der hier vorgeschlagenen Ausführungsform nach Fig. 6 mit praktisch demselben Anstieg wie in der in der Europ. Patentanmeldung 93 890 058.6 vorgeschlagenen Einrichtung, in der zwei Dreielektroden-Gitterlinsen zur Abbildung der Öffnungen einer Maske verwendet werden (Fig. 7), wobei das Verzeichnungsminimum noch geringer ist als in der obgenannten Anmeldung. Zusammen mit der hohen Telezentrizität führt dies zu einer Schärfentiefe von ca 10μm, welche wesentlich besser ist als die in einer üblichen Abbildung mit Lichtoptik erzielbare Schärfentiefe. Beispielsweise ist bei der Photolithographie mit hochenergetischem UV-Licht ("deep UV") bei Herstellung von Strukturen

von 0,2μm die Schärfentiefe ebenfalls im Bereich von nur einigen Zehntel μm. Um mit dieser geringen Schärfentiefe integrierte Schaltkreise produzieren zu können, muß bei der Lichtoptik die Oberfläche des Wafers eingeebnet werden und die Lithographie darf nur in der obersten Schicht stattfinden ("top surface imaging"), was mit hohen Kosten verbunden ist.

b) In den Anordnungen nach Fig. 1b und 2 ergibt sich, wie aus Fig. 3a und 3b schematisch zu erkennen ist, auch für den chromatischen Fehler eine Kompensation durch die Wirkungen der beiden Sammellinsen L1 und L2 für eine bestimmte Bildebene E hinter der vor dem Wafer W angeordneten zweiten Sammellinse L2. Ein Strahl (in Fig. 3 in unterbrochenem Linienzug dargestellt) mit etwas kleinerer Energie $E_0 - \Delta E_0$ als der Sollenergie $E_0$ wird in der die Maske M als eine Elektrode enthaltenden Linse G3 bzw. G2+L1 stärker abgelenkt als ein Strahl mit Sollenergie (in vollen Linien dargestellt) wird und trifft infolgedessen die vor dem Wafer W angeordnete Linse L2 in größerer Achsenferne als der Sollstrahl und wird daher aufgrund seiner geringeren Energie stärker gegen die optische Achse zurückgelenkt, so daß er in einer bestimmten Entfernung hinter der vor dein Wafer W angeordneten Sammellinse L2 den Sollstrahl trifft. In dieser Ebene E verschwindet der chromatische Fehler erster Ordnung. Es verbleibt auch hier ein Restfehler, der chromatische Fehler 2. Ordnung, d.h. ein Fehler proportional zum Quadrat der Energieabweichung vom Sollstrahl.

Bei der Anordnung nach Fig. 1a kann zur Minimierung des chromatischen Fehlers die Waferlinse WL eingesetzt werden.

c) Die drei relevanten Ebenen, nämlich die Gaußsche Bildebene der Maske M , die Ebene minimaler Verzeichnung (Fig. 1 und 2) und die Ebene minimalen chromatischen Fehlers (Fig. 3) werden im allgemeinen nicht zusammenfallen. Durch geeignete Wahl der Linsen und der Lage der Ionenquelle Q auf der ionen-optischen Achse kann jedoch erreicht werden, daß unter Beibehaltung des annähernd parallelen Strahlenganges am Ausgang der Linse L2 die genannten drei Ebenen zusammenfallen. Wird dann der Wafer W dort angeordnet, wo die drei Ebenen zusammenfallen, so bewirkt dies, daß sowohl die Verzeichnung als auch der chromatische Fehler minimal werden.

Bei allen hier beschriebenen Ausführungsformen mit Cross-over (Fig. 1a, Fig. 2, Fig. 6) wird am Cross-over eine möglichst hohe Teilchenenergie erzielt, was den Vorteil bringt, daß die sogenannten stochastischen Raumladungseffekte minimiert werden. Der Cross-over liegt in allen Fällen im feldfreien Raum vor der Linse L2.

Stochastische Teilchenablenkungen werden zum Beispiel in der Arbeit "stochastic ray-deflections in focused particle beams" von A.Weidenhausen, Speer und H.Rose in Optik 69 (1985), Seiten 126 bis 134, behandelt. Der stochastische Raumladungseffekt führt zu Auflösungsfehlern bei der Abbildung, d.h. zu einer Verminderung der maximal erreichbaren Auflösung der Ionenoptik. Die Stärke dieses Effekts hängt unter anderem von der Energie am Cross-over ab, und zwar nach obiger Arbeit gemäß

$$\delta x \sim E^{-5/4}$$

wobei δx die Auflösungsverschlechterung und
E die Energie der Ionen am Cross-over ist.

Die nachfolgende Tabelle zeigt die Berechnungs-Ergebnisse für das Ausführungsbeispiel eines erfindungsgemäßen Ionenprojektionslithographiesystems wie es in Fig. 6 dargestellt wird.

TABELLE I

| | |
|---|---|
| Abstand Quelle-Maske | 1,6 m |
| Abstand Maske-Wafer | 2,2 m |
| Bildfeldgröße auf der Maske | 60x60 mm$^2$ |
| Abbildungsmaßstab (Verkleinerung) | 3:1 |
| Spannungsverhältnis an G2 | 1,082 |
| Spannungsverhältnis an L1 | 18,16 |
| Spannungsverhältnis zwischen der ersten und dritten Elektrode von L2 | 0,75 |
| Spannungsverhältnis zwischen der ersten und zweiten Elektrode von L2 | 0,1825 |
| max. Verzeichnung * | <10 nm |
| max. chromatische Verbreiterung | 50 nm** |
| | 20 nm*** |
| max. Strahldivergenz nach dem Linsensystem | <2 mrad |

\* max. Abweichung irgendeines Bildpunktes von der idealen Abbildung

\*\* für eine Energieverschmierung der Ionen am Ionenquellenausgang E/E=0.0003, wobei E die Energie der Ionen am Ausgang der Ionenquelle ist.

\*\*\* für Ionenquellen, bei welchen die Ionen am Ausgang geringere Energieverschmierung aufweisen, nämlich E/E=0.0001.

Unter dem obigen Begriff Spannungsverhältnis zwischen zwei Elektroden einer Linse mit den Potentialen $U_1$ bzw. $U_2$ ist das folgende Verhältnis zu verstehen:

$$\frac{(U_2-U_o)}{(U_1-U_o)},$$

wobei $U_0$ jenes Potential ist, bei welchem die kinetische Energie des geladenen Teilchens gleich Null wäre.

**Patentansprüche**

1. Teilchenoptisches Abbildungssystem für Lithographiezwecke, mit einer Teilchenquelle zur Abbildung einer auf einer Maskenfolie befindlichen Struktur in Gestalt einer oder mehrerer transparenter Stellen, insbesondere Öffnungen über mindestens zwei in Strahlrichtung vor einem Wafer angeordnete elektrostatische Linsen auf den Wafer, wobei eine der Linsen eine Gitterlinse ist, welche von einer oder zwei Rohrelektroden (R1, R2) und einer im Strahlengang angeordneten Platte mit Öffnungen gebildet ist, wobei die Platte normal zur optischen Achse (D) angeordnet ist, dadurch gekennzeichnet, daß die Platte von der Maskenfolie (M) gebildet ist, welche die mittlere oder die in Strahlrichtung erste Elektrode der Gitterlinse bildet.

2. Abbildungssystem nach Anspruch 1, dadurch gekennzeichnet, daß sich im Strahlengang zwischen Maske und Wafer eine weitere Linse, welche aus einer im wesentlichen rohrförmigen Elektrode und einer Platte besteht, befindet, wobei die Platte vom Wafer gebildet wird, und die rohrförmige Elektrode unmittelbar vor dem Wafer positioniert ist.

3. Abbildungssystem nach Anspruch 1 oder 2, dadurch gekennzeichnet, daß die Maske die mittlere Elektrode einer Dreielektroden-Gitterlinse ist, und die zweite Linse zwischen Maske und Wafer als Immersionslinse ausgebildet ist.

4. Abbildungssystem nach Anspruch 1 oder 2, dadurch gekennzeichnet, daß die Maske die mittlere Elektrode einer Dreielektroden-Gitterlinse ist, und die zweite Linse zwischen Maske und Wafer als asymmetrische Einzel linse ausgebildet ist.

5. Abbildungssystem nach Anspruch 1, dadurch gekennzeichnet, daß die Maske die erste Elektrode einer Zweielektroden-Gitterlinse ist, eine zweite, auf diese folgende Linse als Zweielektroden-Immersionslinse und eine dritte und letzte Linse zwischen Maske und Wafer als asymmetrische Einzellinse ausgebildet ist.

6. Abbildungssystem nach einem der Ansprüche 1 bis 5, dadurch gekennzeichnet, daß sich der Kreuzungspunkt der Ionen im feldfreien Raum befindet.

7. Abbildungssystem nach Anspruch 6, dadurch gekennzeichnet, daß die Energie der Ionen im Bereich des Kreuzungspunktes höher ist als auf dem Wafer.

8. Abbildungssystem nach einem der Ansprüche 1 bis 4, dadurch gekennzeichnet, daß der Strahlengang zwischen Maske und Wafer keinen Kreuzungspunkt aufweist.

**Claims**

1. Particle beam optic imaging system for lithographic purposes, comprising a particle source, for the purpose of imaging onto the wafer a structure located on a masking foil in the form of one or a plurality of transparent spots, in particular holes, by way of at least two electrostatic lenses arranged in the beam direction in front of a wafer, wherein one of the lenses is a so-called grating lens which is formed by one or two tube electrodes (R1, R2) and a plate which comprises holes and is arranged in the beam path, wherein the plate is arranged perpendicular to the optical axis (D), characterised in that the plate is formed by the masking foil (M) which forms the middle or as seen in the beam direction the first electrode of the grating lens.

2. Imaging system according to claim 1, characterised in that a further lens is arranged in the beam path between the mask and wafer, which lens consists of a substantially tubular electrode and a plate, wherein the plate is formed by the wafer and the tubular electrode is positioned immediately in front of the wafer.

3. Imaging system according to claim 1 or 2, characterised in that the mask is the middle electrode of a three-electrode grating lens and the second lens is formed as an immersion lens between the mask and wafer.

4. Imaging system according to claim 1 or 2, characterised in that the mask is the middle electrode of a three electrode grating lens and the second lens is formed as an asymmetric single lens between the mask and the wafer.

5. Imaging system according to claim 1, characterised in that the mask is the first electrode of a two-electrode grating lens, a second lens in the form of a two electrode immersion lens follows this lens and a third and final lens is formed as an asymmetric single lens between the mask and the wafer.

6. Imaging system according to any one of claims 1 to 5, characterised in that the cross-over point of the ions is located in the field-free space.

7. Imaging system according to claim 6, characterised in that the energy of the ions in the region of the cross-over point is higher than on the wafer.

8. Imaging system according to any one of claims 1 to 4, characterised in that the beam path between the mask and the wafer does not comprise a cross-over point.

## Revendications

1. Système de formation d'images dans le domaine de l'optique des particules, pour lithographie, comportant une source de particules pour former l'image d'une structure située sur une feuille formant masque, sous la forme d'un ou de plusieurs emplacements transparents, notamment d'ouvertures, sur une plaquette par l'intermédiaire d'au moins deux lentilles électrostatiques disposées en avant de la plaquette dans la direction du rayonnement, l'une des lentilles étant une lentille à réseau, qui est formée par ou deux électrodes tubulaires (R1, R2) et par une plaque disposée dans le trajet du rayonnement, la plaque étant disposée perpendiculairement à l'axe optique (D), caractérisé en ce que la plaque est formée par la feuille formant masque (M), qui forme l'électrode médiane ou la première électrode, dans la direction du rayonnement, de la lentille à réseau.

2. Système de formation d'images selon la revendication 1, caractérisé en ce qu'entre le masque et la plaquette dans le trajet du faisceau est disposée une autre lentille, qui est constituée par une électrode essentiellement de forme tubulaire et une plaque, la plaque étant formée par la plaquette, et que l'électrode de forme tubulaire est positionnée directement en avant de la plaquette.

3. Système de formation d'images selon la revendication 1 ou 2, caractérisé en ce que le masque est l'électrode centrale d'une lentille à réseau comprenant trois électrodes, et que la seconde lentille située entre le masque et la plaquette est agencée sous la forme d'une lentille à immersion.

4. Système de formation d'images selon la revendication 1 ou 2, caractérisé en ce que le masque est l'électrode centrale d'une lentille à réseau comprenant trois électrodes, et que la seconde lentille située entre le masque et la plaquette est agencée sous la forme d'une lentille asymétrique.

5. Système de formation d'images selon la revendication 1, caractérisé en ce que le masque constitue la première électrode d'une lentille à réseau comportant deux électrodes, qu'une seconde lentille, disposée à la suite de la précédente, est agencée sous la forme d'une lentille à immersion à deux électrodes et qu'une troisième et dernière lentille située entre le masque et la plaquette est agencée sous la forme d'une lentille asymétrique.

6. Système de formation d'images selon l'une des revendications 1 à 5, caractérisé en ce que le point de croisement des ions est situé dans l'espace exempt de champ.

7. Système de formation d'images selon la revendication 6, caractérisé en ce que l'énergie des ions est plus élevée dans la zone du point de croisement que sur la plaquette.

8. Système de formation d'images selon l'une des revendications 1 à 4, caractérisé en ce que le trajet de rayonnement entre le masque et la plaquette ne comporte aucune point de croisement.

FIG. 1a

FIG.2

Fig. 1b

Fig. 8

FIG. 3a

FIG. 3b

FIG.4

U 2

U 1 — R1

U 3 — R2

$v_1$

$r_2$

D

M

P

N

L1

EP 0 739 531 B1

FIG.5

EP 0 739 531 B1

FIG.6

W
0kV
111,6390kV
−49,1802kV
136,7190kV
137,5406kV
M
L2
L1
G2
Q

FIG.7